Europäisches Patentamt

**European Patent Office**

Office européen des brevets

(11) Numéro de publication : **0 081 423**
**B1**

# (12) FASCICULE DE BREVET EUROPÉEN

(45) Date de publication du fascicule du brevet :
**30.10.85**

(21) Numéro de dépôt : **82402182.8**

(22) Date de dépôt : **30.11.82**

(51) Int. Cl.⁴ : **H 01 L 23/48, H 01 L 21/60,
H 01 L 29/10, H 01 L 29/91**

(54) **Dispositif semi-conducteur à faible capacité muni de connexions externes prises au moyen de poutres, et procédé de fabrication d'un tel dispositif.**

(30) Priorité : **09.12.81 FR 8123027**

(43) Date de publication de la demande :
**15.06.83 Bulletin 83/24**

(45) Mention de la délivrance du brevet :
**30.10.85 Bulletin 85/44**

(84) Etats contractants désignés :
**DE GB NL SE**

(56) Documents cités :
GB-A- 2 067 354
US-A- 4 180 422
ELECTRONICS LETTERS, vol. 12, no. 24, 25 novembre 1976, pages 648-650, Hitchin Herts, G.B. J.A. CALVIELLO et al.: "Novel GaAs metallised diode configuration to reduce skin-effect contributions at high frequencies"

(73) Titulaire : **THOMSON-CSF**
**173, Boulevard Haussmann**
**F-75379 Paris Cedex 08 (FR)**

(72) Inventeur : **Henry, Raymond**
**THOMSON-CSF SCPI 173, bld Haussmann**
**F-75379 Paris Cedex 08 (FR)**
Inventeur : **Bouvet, Jean-Victor**
**THOMSON-CSF SCPI 173, bld Haussmann**
**F-75379 Paris Cedex 08 (FR)**
Inventeur : **Lacombe, Jean**
**THOMSON-CSF SCPI 173, bld Haussmann**
**F-75379 Paris Cedex 08 (FR)**

(74) Mandataire : Taboureau, James et al
**THOMSON-CSF SCPI 173, Bld Haussmann**
**F-75379 Paris Cedex 08 (FR)**

## Description

La présente invention concerne un dispositif semiconducteur à faible capacité parasite, du type de ceux dont les connexions externes sont prises au moyen de poutres métalliques soudées à plat sur la pastille semiconductrice mais elle s'applique à la technologie dite « flip chip » de report à l'envers d'un composant, les poutres étant dans ce cas réduites à des plots métalliques. Ces deux technologies sont bien connues sous leurs vocables anglais de « beam-lead » et « flip-chip », respectivement.

Elle concerne plus particulièrement les dispositifs semiconducteurs travaillant à des fréquences égales ou supérieures à 1 GHz, pour lesquelles les capacités parasites entre au moins l'une des poutres et le substrat sont très fortement diminuées selon l'invention.

Sans que cela constitue une limite à l'invention, celle-ci sera exposée en s'appuyant sur le cas d'une diode, la diode étant à la base de tout composant semiconducteur plus complexe, tel que le transistor par exemple.

Toute diode, qu'elle soit à jonction, de type pn, ou Schottky, à métal semiconducteur, comporte un substrat qui supporte la ou les couches actives de la diode, de faible épaisseur par rapport à celle du substrat. Celui-ci est lui-même constitué d'un matériau semiconducteur, qu'on a choisi dopé, de type $n^+$ par exemple — sans que ceci soit limitatif — car ceci facilite l'élaboration de la diode, le substrat apportant d'une part le support mécanique et d'autre part au moins une couche active de la diode.

Etant donné par ailleurs que les connexions extérieures sont, comme cela a été précisé, des poutres métalliques fixées à plat sur la surface de la pastille et qu'au moins une poutre est soutenue par une couche d'isolant, hors de la région de contact, de façon à ne pas court-circuiter le contact avec la couche active sous-jacente à la poutre, il se forme des condensateurs parasites ayant une poutre comme première armature, le substrat conducteur comme deuxième armature et la couche isolante comme diélectrique.

Un perfectionnement déjà connu consiste à creuser un caisson dans le matériau semiconducteur — par tout procédé connu de l'homme de l'art — sous une partie de la poutre considérée et à remplacer le matériau semiconducteur manquant dans ce caisson par un matériau isolant, du verre par exemple. L'épaisseur de diélectrique du condensateur parasite est ainsi augmentée ce qui va dans le sens de la diminution de capacité. Par contre, la surface d'armature constituée non plus par une surface de substrat sensiblement égale à la surface de la poutre, mais constituée désormais par la partie concernée du substrat conducteur dans la cuvette creusée, légèrement augmentée, ce qui va dans le sens contraire d'augmentation de la capacité parasite, néanmoins le bilan demeure très favorable.

Selon l'invention exposée dans les revendications, la partie active d'un dispositif semiconducteur, doté de connexions externes par poutres métalliques, est entourée par un profond sillon — qui n'est donc plus comme dans l'art antérieur limité au voisinage d'une poutre — ce sillon étant ensuite rempli d'un matériau isolant doté de bonnes qualités mécaniques tel que le verre, puis le dispositif semiconducteur est débarassé de la majeure partie de son substrat, dont ne demeure qu'une faible épaisseur, de l'ordre de 1 à 3 fois l'épaisseur d'effet de peau à la fréquence de travail du semiconducteur. Ainsi, le dispositif semiconducteur se présente-t-il sous une forme suspendue par ses poudres de connexions extérieures, en pont par rapport à un anneau externe de verre qui remplace le support mécanique que constitue le substrat dans l'art connu. Avec la suppression du substrat, dans sa majeure partie, est supprimée l'une des armatures d'un condensateur parasite.

De façon plus précise, l'invention exposée dans les revendications concerne un dispositif semiconducteur à faible capacité parasite, muni de connexions externes prises au moyen de poutres métalliques fixées à plat sur la pastille semiconductrice comportant au moins une couche superficielle supportée par un substrat, caractérisé en ce que le support mécanique de ce dispositif est un cadre d'un matériau électriquement isolant et rigide, qui entoure complètement la pastille semiconductrice, et sur lequel s'appuient les poutres de connexions extérieures, et en ce que, l'intérieur de ce cadre, le substrat est partiellement éliminé, et a, sous au moins une couche superficielle formant jonction, une épaisseur réduite comprise entre une et environ trois fois l'effet de peau dudit dispositif, à la fréquence de travail de ce dispositif.

L'invention sera mieux comprise par la description qui suit d'exemples de réalisation, lesquels s'appuient sur les figures annexées qui représentent :

figure 1   une vue en coupe d'une diode Schottky selon l'art connu ;

figure 2   une étape intermédiaire de la fabrication d'une diode Schottky selon l'invention ;

figure 3   une diode Schottky selon l'invention ;

figure 4   variante possible d'une diode Schottky précédente ;

figure 5   un premier type de diode à jonction selon l'invention ;

figure 6   un second type de diode à jonction selon l'invention.

Dans le but de simplifier le texte, ainsi que les figures, l'invention sera exposée en s'appuyant sur le cas d'une diode. Parmi les différents dispositifs semiconducteurs qui relèvent de l'invention, elle s'applique plus particulièrement aux diodes, à jonction ou Schottky, dont le substrat est généralement en silicium ou en matériau de la famille III-V, GaAs par exemple, et est particulièrement intéressante dans le domaine millimétrique, pour lequel la valeur très faible de la capacité de jonction exige une réduction maximale de la capacité parasite entre poutres.

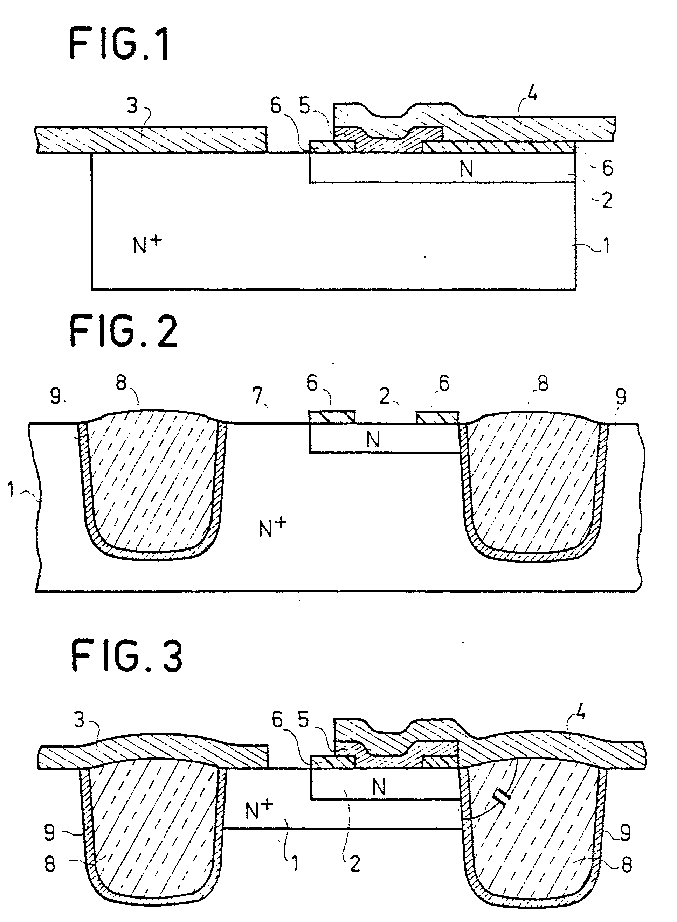

La figure 1 représente la vue en coupe d'une diode Schottky selon l'art connu. Le substrat 1 de cette diode est un matériau semiconducteur dopé de type $n^+$ par exemple et sur lequel a été épitaxiée une couche 2 de type n. La reprise de contact sur la zone $n^+$ se fait soit par élimination localisée de la couche n ou par diffusion ou implantation d'un caisson $n^+$ rejoignant le substrat $n^+$. Un premier contact ohmique, le contact de cathode 3 est assuré par une poutre métallique réalisée selon la chaîne SiPt-Ti-Pt-Or, si le matériau de base de la diode est du silicium. Le fait que sous la poutre 3 le matériau soit de type $n^+$ est nécessaire pour pouvoir réaliser le contact ohmique.

Le second contact, ou contrat d'anode 4, est réalisé de préférence au moyen de la même chaîne Ti-Pt-Or, mais une épaisseur de métal 5 assurant le contact Schottky qui est soit le titane, soit par exemple chrome, molybdène... suivant le seuil direct désiré, est intercalée entre la poutre 4 et la région n2.

De façon à éviter que la poutre d'anode 4 ne soit en contact avec la région n2 en dehors du contact Schottky 5, la poutre d'anode est mécaniquement supportée et électriquement isolée par une couche d'un isolant 6, qui est par exemple de l'oxyde de silicium.

Du fait que les contacts externes sont dans le cas présent pris par des poutres métalliques fixées à plat sur la surface supérieure du dispositif semiconducteur, il se forme un système de condensateurs parasites entre d'une part, l'électrode d'anode 4, qui est un ruban métallique, et d'autre part, la couche n2 et le substrat $n^+$ 1, la couche 6 d'isolant étant le diélectrique commun des différents condensateurs parasites.

Ces différents condensateurs parasites ont une capacité relativement très importante et gênante aux fréquences de travail, c'est-à-dire largement supérieures à 1 GHz, du fait de l'épaisseur très faible de la couche de diélectrique 6, et du fait de la relativement grande surface des poutres métalliques, surface nécessaire pour avoir une bonne solidité mécanique de l'ensemble, avoir une bonne maniabilité du dispositif semiconducteur fabriqué, et assurer une inductance série faible en hyperfréquence.

La surface des armatures de ces condensateurs est assez précisément définie par la surface de la poutre 4, mais relativement mal définie du côté de la seconde armature par les surfaces des couches $n^+$ 1 et n2, qui participent à la seconde armature de ces condensateurs parasites.

Selon l'invention, les condensateurs parasites entre une poutre et le substrat sont annulés par suppression presque totale du substrat, ou tout au moins fortement diminués si une mince couche du substrat doit être maintenue, cette couche participant au fonctionnement de la diode. Ainsi, dans son fondement, l'invention élimine le matériau sous au moins une poutre, et tend vers un condensateur à air, de valeur $\varepsilon_1$ fois plus faible qu'en laissant le matériau de constante diélectrique relative par rapport à l'air $\varepsilon_1$, soit environ 12 pour le silicium. Le substrat étant supprimé, les poutres sont maintenues par un cadre, en verre de préférence.

La figure 2 représente une étape de fabrication d'un dispositif semiconducteur selon l'invention : ce dispositif est une diode Schottky, mais ne présente aucun caractère limitatif à l'invention. La fabrication suppose un procédé de réalisation collective, ce qui est normal pour ce type de dispositifs.

Sur une plaquette de substrat 1, de type $n^+$ par exemple, est réalisée par épitaxie une zone n2 puis un caisson $n^+$ par implantation ou diffusion pour reprise de contact sur le substrat. Une couche isolante 6 est obtenue en surface de la plaquette, soit par oxydation si le matériau est du silicium, soit par dépôt dans les autres cas. Ensuite, cette couche isolante est attaquée de façon à ne laisser subsister qu'un masque isolant sur la région 2, ce masque comportant en son centre une aire d'accès au caisson 2, pour une future prise de contact Schottky.

A ce point de la réalisation, un sillon 8, profond et annulaire, entourant la diode, est obtenu par attaque du substrat. A titre purement indicatif, pour une diode fonctionnant en hyperfréquences, le sillon 8 a une profondeur comprise entre 20 et 50 μm à comparer avec l'épaisseur du caisson 2 qui est de l'ordre de 0,4 μm. Le sillon 8 est comblé avec un matériau isolant, de préférence un verre fondu, dont le coefficient de dilatation est bien adapté à celui du substrat 1 : c'est ce sillon rempli de matériau rigide qui formera le cadre support du dispositif semiconducteur.

La largeur du sillon 8 est de l'ordre de 200 μm par exemple.

Il est intéressant, avant de combler le sillon 8 avec du verre, de recouvrir sa paroi d'une couche diélectrique 9, inerte aux réactifs d'attaque chimique. Cette couche 9 peut être, par exemple, du nitrure de silicium $Si_3N_4$. Sa fonction sera exposée ultérieurement.

La suite de la fabrication d'un dispositif selon l'invention est représentée en figure 3.

Sur la plaquette, en l'état de la figure 2, sont déposées d'abord une première métallisation 5 pour assurer un contact Schottky sur le caisson n2, ensuite une seconde métallisation au cours de laquelle on fait croître une première poutre 3 qui assure le contact cathodique, ohmique, avec le caisson $n^+$, et une seconde poutre 4 qui assure le contact anodique, Schottky, avec le caisson n. Les techniques de dépôt et gravure des métallisations sont connues de l'homme de l'art.

La plaquette est alors retournée, et la majeure partie du substrat 1 est attaquée par sa face arrière par voie chimique, en phase liquide ou plasma, de façon à n'en laisser subsister qu'une très faible épaisseur, sous le caisson n2. La faible épaisseur de substrat conservée a pour fonction de faciliter le passage du courant dans la diode ; si elle n'existait pas, la diode serait trop résistante.

Il est évident que, au lieu d'être mise à plat et attaquée par sa face arrière située dans un plan horizontal, la plaquette peut également être masquée par une résine sur sa face active, comportant les poutres, et introduite dans le liquide réactif à la verticale.

Au cours de cette attaque, le caisson 8 est mis à nu, de sorte que, tandis qu'au début de l'opération on avait un caisson de verre 8 dans le substrat 1, à la fin de l'opération on a ce qui reste du substrat 1 dans un anneau de verre 8. C'est pour éviter l'attaque de l'anneau de verre 8 par le réactif de suppression de substrat 1 qu'il est préférable de disposer une couche 9, insensible à l'attaque chimique.

Sur la figure 3, il y a encore, sous la poutre d'anode 4, une légère épaisseur de substrat n+ 1. Celui-ci ne communique avec le verre de l'anneau 8 et la poutre d'anode 4, qu'une très faible capacité parasite au dispositif semiconducteur réalisé selon l'invention. Bien plus faible que la capacité parasite qui existe, dans un dispositif selon l'art connu, représenté en figure 1. Selon l'invention, la capacité parasite, représentée symboliquement en figure 3, a pour armature la surface parasite, représentée symboliquement en figure 3, a pour armature la surface latérale de la couche restante de substrat, correspondant à son épaisseur, qui est de beaucoup plus faible que la surface de jonction n+ n de la figure 1 sous la poutre 4.

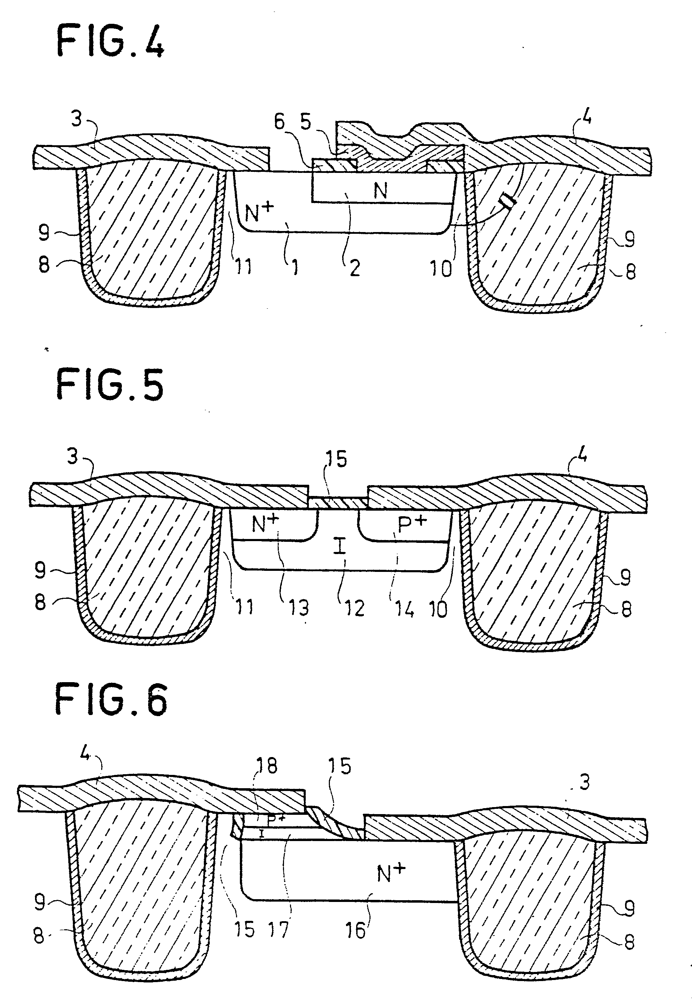

La figure 4 représente une variante souvent préférable de réalisation de la diode Schottky précédente.

Il est possible de diminuer encore le condensateur parasite résiduel, décrit en figure 3, en éliminant totalement sous la poutre d'anode 4 le matériau qui constitue l'une des armatures de ce condensateur parasite. Celui-ci demeure néanmoins, et est symbolisé sur la figure 4, mais sa valeur est encore abaissée, puisqu'à un matériau de constante diélectrique de l'ordre de 12 est substitué l'air de constante diélectrique égale à 1.

Ce résultat est obtenu en poursuivant localement l'attaque du substrat n+ 1 et du caisson n2, sur un dispositif selon la figure 3, jusqu'à atteindre la couche d'isolant 6 : il n'y a alors, dans cette région 10, plus aucun contact entre les matériaux constitutifs de la diode et l'anneau de verre qui l'entoure.

Cette attaque localisée est obtenue en masquant, sur une diode telle qu'en figure 3, la face arrière de ce qui reste du substrat 1, sauf à proximité de la poutre d'anode 4 : l'attaque ne portera plus que sur cette région 10 laissée à découvert. Il peut être d'ailleurs, vu les très petites dimensions de ces dispositifs, plus facile de ne masquer que la partie centrale du substrat 1 : à l'issue de la seconde attaque, il y a donc un sillon tout autour de la diode, ce sillon d'air apparaissant en 10 sous la poutre d'anode 4 et en 11 sous la poutre de cathode 3.

La figure 5 représente un premier exemple d'application de l'invention à une diode de type PIN, dans une structure dite de surface ou horizontale.

Pour obtenir une telle diode, seules les premières opérations de fabrications sont différentes de celles décrites au sujet de la figure 3.

Le substrat 12 de départ est un matériau de haute résistivité, dans lequel sont réalisés, par des techniques connues, un caisson n+ 13 et un caisson p+ 14. Puis un sillon 8 est creusé dans le substrat, et comblé par du verre, et les métallisations de poutres 3 et 4 déposées, la poutre de cathode 3 étant en contact avec le caisson n+ 13 et la poudre 4 d'anode en contact avec le caisson p+ 14.

Le substrat 12 est alors partiellement éliminé par attaque chimique. Dans la version représentée en figure 5, une seconde attaque chimique a totalement isolé la diode PIN de l'anneau de verre qui l'entoure, par un sillon d'air 10-11.

Les jonctions en surface de la pastille sont protégées par une passivation 15.

La figure 6 représente une seconde application de l'invention à une diode PIN, dans une structure verticale.

Pour réaliser une telle diode, le substrat de départ 16 est de type n+ : une couche de haute résistivité 17 puis une couche de type p+ 18 sont déposées sur ce substrat 16, puis délimitées à la zone de contact d'anode 3.

La suite des opérations de fabrication d'une telle diode verticale est absolument comparable à celle qui a été précédemment décrite.

A l'issue de la fabrication, les jonctions, qui apparaissent sur les bords de l'empilement PIN, sont protégées par une passivation 15, celle-ci pouvant être faite au départ si on le désire.

Bien que l'invention ait été décrite en s'appuyant sur le cas de diodes, il est évident que son application à des dispositifs plus complexes tels que transistors latéraux dotés de trois connexions externe sous forme de poutres fixées à plat sur la pastille, ainsi que l'adaptation à des matériaux de genre ou de conductivité différente entre dans le domaine de l'invention, qui est précisée par les revendications ci-après.

**Revendications**

1. Dispositif semiconducteur à faible capacité parasite, dont les connexions externes sont réalisées au moyen de poutres métalliques (3, 4) fixées à plat sur la surface supérieure d'une pastille semiconductrice (1, 2), comportant au moins une couche superficielle active (2) supportée par un substrat (1) et formant une jonction, caractérisé en ce que le support mécanique de ce dispositif est un cadre (8) d'un matériau électriquement isolant et rigide, qui entoure complètement la pastille semiconductrice, et sur lequel s'appuient les poutres (3, 4) de connexions extérieures, et en ce que le substrat (1) a en particulier sous la couche superficielle (2) formant jonction, une épaisseur faible par rapport à celle du cadre rigide, et comprise entre une environ trois fois l'effet de peau dudit dispositif, à la fréquence de travail de ce dispositif.

2. Dispositif semiconducteur selon la revendication 1, caractérisé en ce que le matériau constitutif du cadre (8), qui entoure la pastille semiconductrice, est un verre, dont le coefficient de dilatation est adapté à celui du matériau constitutif de la pastille semiconductrice (1 + 2).

3. Dispositif semiconducteur selon la revendication 2, caractérisé en ce que le cadre de verre (8) est recouvert par une couche (9) d'un matériau résistant à l'attaque chimique, tel que le nitrure de silicium $Si_3N_4$.

4. Dispositif semiconducteur selon la revendication 1, caractérisé en ce que, en vue de diminuer le condensateur parasite formé entre une poutre (4) le cadre isolant (8) et l'épaisseur de substrat (1), la pastille semiconductrice (1 + 2) est isolée du cadre isolant (8) par un sillon d'air (10), au moins dans la région proche d'une poutre (4).

5. Procédé de fabrication d'un dispositif semiconducteur selon la revendication 1, caractérisé en ce qu'il comporte la suite des opérations suivantes :

— sur une plaquette de substrat (1), réalisation d'au moins une couche superficielle active (2) ;

— creusement, par la face supérieure du substrat (1), d'un sillon (8) délimitant la pastille du dispositif semiconducteur, et entourant une partie du substrat et la couche active (2) ;

— dépôt sur la paroi de ce sillon (8) d'une couche (9) d'un matériau résistant à l'attaque chimique, tel que $Si_3N_4$ ;

— remplissage du sillon (8) par un matériau isolant et rigide, tel que le verre, afin de former le cadre support de la pastille semiconductrice ;

— dépôt d'au moins deux connexions externes, par métallisation et gravure d'au moins deux poutres (3, 4), celles-ci s'appuyant extérieurement sur le matériau isolant du sillon (8) comblé et établissant au moins deux contacts, sur la pastille semiconductrice ;

— attaque par voie chimique, en phase liquide ou plasma, du substrat (1), par sa face inférieure, cette attaque mettant à nu le cadre rigide formé par le sillon rempli de matériau isolant, et étant interrompue lorsque le substrat (1) est réduit, sous la région active (2) à une épaisseur faible par rapport à celle du cadre rigide ;

— passivation par un oxyde (15) des jonctions apparentes sur la surface externe de la pastille semiconductrice.

6. Procédé de fabrication d'un dispositif semiconducteur selon la revendication 5, caractérisé en ce qu'il est complété, après la première attaque chimique du substrat (1), par un masquage de sa face inférieure, ce masquage laissant à nu au moins une zone proche d'une poutre (4), puis par une seconde attaque chimique, qui creuse un second sillon (10) sur toute l'épaisseur de la pastille, laquelle n'a plus de contact avec le cadre de verre (8) dans la zone du second sillon (10).

## Claims

1. A semiconductor device with a low parasitic capacitance, the external connections of which are made of metal stripes (3, 4) attached flatly to the upper surface of a semiconductor dice (1, 2), this dice comprising at least one superficial active layer (2) supported by a substrate (1) and constituting a junction, characterized in that the mechanical support of this device is a frame (8) made of an electrically insulating and rigid material and surrounding completely the semiconductor dice, these stripes (3, 4) of the external connections bearing on said frame, and that the thickness of the substrate (1), particularly underneath the superficial layer (2) forming the junction, is small with respect to that of the rigid frame and is about three times as large the skin effect of said device at the operating frequency of the device.

2. A semiconductor device according to claim 1, characterized in that the material forming the frame (8) surrounding the semiconductor dice is made of glass, the expansion coefficient of which is adapted to that of the material forming the semiconductor dice (1, 2).

3. A semiconductor device according to claim 2, characterized in that the glass frame (8) is covered by a layer (9) of a material resisting to the chemical attack, such as silicium nitride $Si_3N_4$.

4. A semiconductor device according to claim 1, characterized in that in view of the reduction of the parasitic capacitance between a stripe (4), the insulating frame (8) and the remaining thickness of the substrate (1), the semiconductor dice (1, 2) is insulated from the insulating frame (8) by an air drill (10) at least in the zone which is close to a stripe (4).

5. A method for manufacturing a semiconductor device according to claim 1, characterized in that it comprises the following operation steps in succession :

— realization of at least one superficial active layer (2) on a plate of substrate (1) ;

— cutting of a drill (8) into the upper surface of the substrate (1), this drill delimiting the dice of the semiconductor device and surrounding part of the substrate and the active layer (2) ;

— deposition of a layer (9) made of a material resisting to the chemical attack, such as $Si_3N_4$, on the wall of said drill (8) ;

— filling of said drill (8) with an insulating and rigid material such as glass in order to build up the support frame of the semiconductor dice ;

— deposition of at least two external connections by metallization and engraving of at least two stripes (3, 4), these stripes being applied externally to the insulating material of the filled in drill (8) and realizing at least two contacts on the semiconductor dice ;

— attack of the lower surface of the substrate (1) by chemical means in the liquid phase or in plasma, thereby denuding the rigid frame constituted by the drill filled with insulating material, the attack being stopped as soon as the substrate (1) is reduced to a small thickness with respect to the rigid frame underneath the active region (2) ;

— passivation of the junctions which appear on the outer surface of the semiconductor dice, by an oxide (15).

6. A method for manufacturing a semiconductor device according to claim 5, characterized in that it is completed, after the first chemical attack of the substrate (1), by a masking operation of the lower surface, this masking leaving free at least one zone close to a stripe (4), then by a second chemical attack by which a second drill (10) is cut along the entire thickness of the dice, the dice having no more contact with the glass frame (8) in the zone of the second drill (10).

**Patentansprüche**

1. Halbleiteranordnung mit niedriger Störkapazität, dessen Außenanschlüsse als Metallstreifen (3, 4) ausgebildet sind, die flach auf die Oberseite eines Halbleiterplättchens (1, 2) aufgebracht sind, wobei dieses Plättchen mindestens eine einen Übergang bildende oberflächliche aktive Schicht (2) enthält, die von einem Substrat (1) getragen wird, dadurch gekennzeichnet, daß der mechanische Träger dieser Anordnung ein Rahmen (8) aus einem elektrisch isolierenden und starren Material ist, der das Halbleiterplättchen vollständig umgibt und auf dem sich die Streifen (3, 4) der Außenanschlüsse abstützen, und daß die Dicke des Substrats (1), insbesondere unter der oberflächlichen aktiven, den Übergang bildenden Schicht (2), im Vergleich zur Dicke des starren Rahmens gering ist und etwa das Dreifache des Skineffekts der Anordnung bei der Arbeitsfrequenz beträgt.

2. Halbleiteranordnung nach Anspruch 1, dadurch gekennzeichnet, daß das den Rahmen (8), der das Halbleiterplättchen umgibt, bildende Material ein Glas ist, dessen Ausdehnungskoeffizient an den Ausdehnungskoeffizienten des Materials angepaßt ist, das das Halbleiterplättchen (1, 2) bildet.

3. Halbleiteranordnung nach Anspruch 2, dadurch gekennzeichnet, daß der Rahmen (8) aus Glas mit einer Schicht (9) eines gegen chemische Angriffe widerstandsfähigen Materials, wie z. B. Siliciumnitrid $Si_3N_4$, bedeckt ist.

4. Halbleiteranordnung nach Anspruch 1, dadurch gekennzeichnet, daß zur Verringerung der Störkapazität zwischen einem Streifen (4), dem isolierenden Rahmen (8) und der Restdicke des Substrats (1) das Halbleiterplättchen (1, 2) vom isolierenden Rahmen (8) durch eine Luftrille (10) mindestens in der Zone in der Nähe eines Streifens (4) isoliert ist.

5. Verfahren zur Herstellung einer Hableiteranordnung nach Anspruch 1, dadurch gekennzeichnet, daß es folgende Verfahrensschritte in Aufeinanderfolge aufweist :

— Bildung mindestens einer oberflächlichen aktiven Schicht (2) auf einer Substratplatte (1) ;

— Ausschneiden einer Rille (8) auf der Oberseite des Substrats (1), wobei diese Rille das Plättchen der Halbleiteranordnung umschließt und einen Teil des Substrats sowie die aktive Schicht (2) einschließt ;

— Ablagerung einer Schicht (9) aus einem gegen chemische Angriffe widerstandsfähigen Material, wie z. B. $Si_3N_4$ auf der Wand dieser Rille (8) ;

— Ausfüllen dieser Rille (8) mit einem isolierenden und starren Material, wie z. B. Glas, um den tragenden Rahmen für das Halbleiterplättchen zu bilden ;

— Aufbringen mindestens zweier Außenanschlüsse durch Metallisierung und Gravur mindestens zweier Streifen (3, 4), die sich nach außen auf dem isolierenden Material der aufgefüllten Rille (8) abstützen und mindestens zwei Kontakte auf dem Halbleiterplättchen ergeben ;

— Ätzen der unteren Seite des Substrats 1 auf chemischem Wege in flüssiger Phase oder Plasma, um den starren Rahmen freizulegen, der von der mit dem isolierenden Material gefüllten Rille gebildet wird, wobei das Ätzen unterbrochen wird, wenn das Substrat (1) unter der aktiven Zone (2) auf eine im Vergleich zur Dicke des starren Rahmens geringe Dicke verringert wurde ;

— Passivierung der auf der äußeren Oberfläche des Halbleiterplättchens offenliegenden Übergänge mit einem Oxid (15).

6. Verfahren zur Herstellung einer Halbleiteranordnung nach Anspruch 5, dadurch gekennzeichnet, daß es nach dem ersten Ätzangriff auf das Substrat (1) durch eine Maskenabdeckung der Unterseite vervollständigt wird, wobei diese Abdeckung mindestens eine Zone in der Nähe eines Streifens (4) freiläßt, worauf ein zweiter chemischer Ätzvorgang eingeleitet wird, mit dem eine zweite Rille (10) über die ganze Dicke des Plättchens erzeugt wird, so daß das Plättchen keinen Kontakt mehr mit dem Rahmen (8) aus Glas in der Zone der zweiten Rille (10) besitzt.

# FIG.1

# FIG.2

# FIG.3

# FIG.4

# FIG.5

# FIG.6

2